# EUROPÄISCHE PATENTSCHRIFT

(11) **EP 2 514 045 B1**
(45) Veröffentlichungstag und Bekanntmachung des Hinweises auf die Patenterteilung: **30.11.2016**
(21) Anmeldenummer: 10765944.3
(22) Anmeldetag: 21.09.2010
(51) Int. Cl.: H01S 3/06, H01S 3/213, H01S 3/08, H01L 31/055

(54) **LICHTQUELLE UND VERFAHREN ZUR LICHTERZEUGUNG**
LIGHT SOURCE AND METHOD FOR PRODUCING LIGHT
SOURCE DE LUMIÈRE ET PROCÉDÉ DE GÉNÉRATION DE LUMIÈRE

(30) Priorität: 19.10.2009 DE 102009049962
(43) Veröffentlichungstag der Anmeldung: 24.10.2012
(73) Patentinhaber: Rheinische Friedrich-Wilhelms-Universität Bonn, 53113 Bonn (DE)
(72) Erfinder: VEWINGER, Frank, 53113 Bonn (DE); WEITZ, Martin, 53127 Bonn (DE); KLÄRS, Jan, 53111 Bonn (DE)
(74) Vertreter: Cohausz Hannig Borkowski Wißgott
(86) Internationale Anmeldenummer: PCT/EP2010/005758
(87) Internationale Veröffentlichungsnummer: WO 2011/047760

(56) Entgegenhaltungen:
- WO-A2-2011/064311
- US-A- 4 199 376
- US-A1- 2004 190 579
- M. OSUGE ET AL: "Spontaneous emsiion and oscillation in a planar microcavity dye laser", JOURNAL OF APPLIED PHYSICS, Bd. 76, Nr. 5, 10. September 1994 (1994-09-10), Seiten 2588-2597, XP002678438,
- A.A. CHERNENKO ET AL: "Modeling of amplification without inversion near transistions from autoionizing levels of ytterbium atoms", LASER PHYSICS, Bd. 10, Nr. 1, 1. Januar 2000 (2000-01-01) , Seiten 133-138, XP002678439,
- V.R. BLOK ET AL: "Feasibility of lasing without inversion in the two level system with split upper levels coupled by microwave radiation", PHYSICAL REVIEW A, Bd. 43, Nr. 9, 1. Mai 1991 (1991-05-01), Seiten 5173-5174, XP002678440,
- J. KLAERS ET AL: "Bose einstein condensation of paraxial light", APPLIED PHYSICS B, Bd. 105, 15. September 2011 (2011-09-15), Seiten 17-33, XP002678441,
- J. KLAERS ET AL: "bose einstein condensation of photons in an optical microcavity", NATURE, Bd. 468, 25. November 2010 (2010-11-25), Seiten 545-548, XP002678442,

## Beschreibung

Die Erfindung betrifft eine Lichtquelle, umfassend einen optischen Resonator und ein darin angeordnetes, zur Lichtemission anregbares optisches Medium. Die Erfindung betrifft weiterhin ein Verfahren zur Lichterzeugung mittels eines optischen Resonators und einem darin angeordneten, zur Lichtemission anregbaren optischen Medium.

Lichtquellen dieser grundsätzlichen Art werden üblicherweise im Stand der Technik als Laser betrieben, bei denen ein zur stimulierten Lichtemission anregbares optisches Medium durch äußere Anregung, beispielsweise durch optisches Pumpen, in der Zustandsbesetzung invertiert wird, um auf dem besetzungsinvertierten Übergang stimulierte Emission und somit eine Lasertätigkeit durch resonante Rückkopplung im Resonator zu erzeugen.

Für solche Laseranwendungen werden üblicherweise optische Medien eingesetzt, die ein Mehrniveausystem, insbesondere 3- oder 4-Niveau-System umfassen, wobei die Lasertätigkeit zwischen zwei Niveaus stattfindet, von denen das untere Niveau schnell entvölkert wird, um so die Besetzungsinversion durch Anregung des oberen Niveaus zu erzielen.

Häufig wird hierbei durch elektrische, chemische oder optische Anregung ein Niveau im Mehrniveausystem des optischen Mediums angeregt, wobei dieser angeregte Zustand sodann zum oberen Laserniveau intern zerfällt und ein Strahlungsübergang zum unteren Laserniveau stattfindet, welches sodann schnell zum Grundzustand entvölkert wird.

Bei einem solchen Laserprozess findet demnach auch eine Energiekonversion, insbesondere beim optischen Pumpen eine Wellenlängenkonversion von der eingestrahlten kurzwelligeren Pumpwellenlänge zur emittierten längerwelligeren Laserwellenlänge statt. Die Wirkungsgrade solcher Laserlichtquellen mit optischen Medien in optischen Resonatoren sind teilweise sehr klein und können daher nur eingeschränkt zur Energie- bzw. Wellenlängenkonversion von Licht eingesetzt werden, haben hingegen den Vorteil hoher Kohärenz und hoher Monochromasie.

Auch schränkt die Notwendigkeit einer Inversion des Mediums den spektralen Arbeitsbereich ein, da nicht für alle optischen Wellenlängenbereiche geeignete 3- oder 4- Niveau Lasermedien verfügbar sind. Beispielsweise erschwert die Zunahme der Spontanemission mit der optischen Frequenz eine Inversion von atomaren Übergängen sehr hoher Übergangsfrequenz, so dass Laserquellen im UV- oder Röntgenbereich nur sehr begrenzt verfügbar sind.

Oftmals bestehen bei lichttechnischen Anwendungen an die Monochromasie und Kohärenz keine so hohen Anforderungen, so dass grundsätzlich auch andere Lichtquellen als die in Wirkungsgrad und Wellenlängenbereich eingeschränkten Lasersysteme zum Einsatz kommen könnten, jedoch im Stand der Technik leider nicht zur Verfügung stehen.

Es ist daher die Aufgabe der Erfindung, eine Lichtquelle der eingangs genannten Art sowie ein Verfahren zur Erzeugung von Licht mittels eines optischen Resonators und einem darin angeordneten, zur Lichtemission anregbaren optischen Medium bereitzustellen, mit denen zum einen ein hoher Energieinsbesondere Wellenlängenkonversionsgrad erzielt wird und zum anderen auch die Möglichkeit besteht, mit hohem Wirkungsgrad Licht zu sammeln und/oder zumindest weitgehend kohärentes Licht zu erzeugen, ohne auf einen Laserprozess mit der üblichen Besetzungsinversion zwischen den beteiligten Niveaus und den damit einhergehenden geringen Wirkungsgrad und begrenzten Wellenlängenbereich zurückgreifen zu müssen.

Erfindungsgemäß wird diese Aufgabe gemäß dem Anspruch 1, wobei das optische Medium wenigstens ein Zwei-Niveau-System, insbesondere wenigstens ein nicht besetzungsinvertiertes Zwei-Niveau-System umfasst, mit zumindest metastabilem unteren Zustand oder einem Grundzustand als unterem Zustand mit hoher Lebensdauer, wobei die optische Länge des wenigstens einen gekrümmten Spiegel umfassenden Resonators so gewählt ist, dass dessen freie spektrale Bandbreite gleich groß oder größer ist als die Absorptions- und/oder Fluoreszenzbandbreite des optischen Mediums und nur eine einzige longitudinale Mode und mehrere transversale Moden des Resonators innerhalb der Fluoreszenzbandbreite angeordnet sind.

Im Gegensatz zu den im Stand der Technik bekannten Laseranwendungen wird demnach hier erfindungsgemäß als ein optisches Medium wenigstens ein Zwei-Niveau-System ausgewählt, wobei sich dieses Zwei-Niveau-System dadurch auszeichnet, dass das untere der beiden beteiligten Niveaus zumindest metastabil ist oder den Grundzustand des gewählten Mediums darstellt. Bevorzugt wird dabei unter einem Zwei-Niveau-System der erfindungsgemäßen Art ein solches verstanden, bei dem mindestens eins der zwei Niveaus verbreitert ist, d.h. das Zwei-Niveau-System muss kein echtes Zwei-Niveau-Systemm sein, sondern kann auch ein "verschmiertes" Mehrniveausystem sein, wie es z.B. bei Farbstoffen oder Festkörpern der Fall ist.

Anders als bei üblichen, für die Lasertätigkeit eingesetzten Medien hat demnach das untere Niveau des erfindungsgemäß verwendeten Zwei-Niveau-Systems eine vergleichsweise lange Lebensdauer, insbesondere eine höhere als das obere der beiden beteiligten zwei Niveaus. Hierdurch wird eine Besetzungsinversion und damit einhergehende Lasertätigkeit vermieden und ein thermodynamisches Gleichgewicht, welches bevorzugt vorgesehen ist, begünstigt.

Dabei kann es sich bei dem eingesetzten optischen Medium selbstverständlich um ein solches handeln, welches mehr als lediglich zwei Zustände hat, wobei jedoch für die erfindungsgemäße Lichtquelle bzw. ein Verfahren zur Erzeugung von Licht nur zwei Niveaus (bevorzugt ein verbreitertes) zum Einsatz kommen, nämlich hier sowohl zum Zweck der Emission der durch die Niveaus definierten Wellenlänge als auch zur, insbesondere mehrfachen Reabsorption der erzeugten Photonen, um wie zuvor beschrieben das thermodynamische Gleichgewicht bevorzugt zu begünstigen. Es handelt sich demnach bevorzugt um eine Zwei-Niveau-System bzw. optisches Medium, dass bzgl. der Emissionswellenlänge optisch dicht ist. Das Pumpen (optisch, elektrisch, chemisch etc) und somit Anregen des oberen, beispielsweise verbreiterten Niveaus der beiden Niveaus des wenigstens einen 2-Niveau-Systems kann auch über Hilfsniveaus erfolgen, die bevorzugt an der erfindungsgemäßen Emission und Reabsorption dann nicht weiter beteiligt sind. Ein wesentlicher Kerngedanke der Erfindung ist es, dass bei der hier beschriebenen Lichtquelle durch die Kombination des Resonators mit dem optischen Medium aufgrund der geschilderten Längenanpassung des Resonators nur eine einzige longitudinale Mode erzeugt werden kann, da die freie spektrale Bandbreite (FSR) durch Verkürzung der Resonatorlänge so gewählt ist, dass eine nächste benachbarte longitudinale Mode des Resonators außerhalb der Fluoreszenzbandbreite des eingesetzten optischen Mediums liegt. Die Patentschrift US20040190579 offenbart einen Laser mit einem kurzen Resonator der nur eine einzige Longitudinale Mode unterstützt. In bevorzugter Weise kann dies erreicht werden, wenn die optische Resonatorlänge L für eine gewünschte Wellenlänge Lambda L = n * (Lambda/2) entspricht und n kleiner gleich 40, bevorzugt n kleiner gleich 10, weiter bevorzugt n kleiner gleich 6 und besonders bevorzugt n gleich 1 gewählt ist.

Bei einer solchen Konfiguration konnte ermittelt werden, dass sich die Photonen innerhalb des Resonators als sogenanntes 2-dimensionales Photonengas beschreiben lassen, wobei das Strahlungsfeld im Resonator lediglich durch den einen longitudinalen Grundmode und mehrere transversale Modem gegeben ist und unterhalb einer kritischen Photonenanzahl im Resonator einer spektralen Bolzmannverteilung folgt mit dem longitudinalen Resonatormode als obere Grenzwellenlänge bzw. oberhalb einer kritischen Photonenanzahl im Resonator einer Bose-Einstein-Verteilung entspricht mit einem in der Intensität gegenüber den transversalen Moden stark überhöhten longitudinalen Mode, wiederum als obere Grenzwellenlänge.

Dabei kann die erfindungsgemäße Lichtquelle bevorzugt im thermodynamischen Gleichgewicht betrieben werden, was durch die Verwendung des wenigstens einen Zwei-Niveau-Systems unterstützt wird, welches bei der Emmisionswellenlänge optisch dicht ist und somit eine Reabsorption der emittierten Photonen bewirkt. Hierbei wird ein thermodynamisches Gleichgewicht besonders gut erzielt, wenn eine Reabsorptionswahrscheinlichkeit der emittierten Photonen größer als 50, bevorzugt größer als 75% ist.

In einer bevorzugten Anwendung kann in das optische Medium innerhalb von dessen Absorptionsbandbreite nicht kohärentes Licht eingestrahlt werden und durch Einstellung der Photonenzahl im Resonator über eine kritische Photonenzahl, wie sie vorangehend genannt wurde, zumindest teilweise kohärentes spektral Bose-Einstein-verteiltes Licht emittiert werden.

So zeigt sich nämlich, dass oberhalb der kritischen Photonenzahl das um den longitudinalen Resonatormode unmittelbar verteilte und in der Intensität stark erhöhte Licht kohärent ist aufgrund einer auftretenden Bose-Einstein-Kondensation des Photonengases bei den geschilderten Betriebsbedingungen im thermodynamischen Gleichgewicht.

Im räumlichen Emissionsprofil des erfindungsgemäßen Resonators, also demjenigen Licht, welches den Resonator durch einen der Spiegel des Resonators verlässt, kann dieser kohärente Lichtanteil des longintudinalen Grundmodes die geringste Divergenz aufweisen und zentriert angeordnet sein, so dass er beispielsweise durch eine Blendenanordnung aus dem räumlichen Profil von den umgebenden Strahlanteilen separiert werden kann.

Die weiteren spektralen Anteile stellen transversale Moden dar, die eine höhere Divergenz aufweisen und den kohärenten Lichtanteil im Wesentlichen ringförmig umgeben und so durch eine Blende zurückgehalten werden können.

Die beschriebene erfindungsgemäße Lichtquelle kann daher in bevorzugter Anwendung dafür eingesetzt werden, um nicht kohärentes Licht in kohärentes Licht umzuwandeln, nämlich insbesondere dann, wenn das optische Medium der erfindungsgemäßen Lichtquelle mit Licht optisch gepumpt wird, welches innerhalb von der Absorptionsbandbreite des eingesetzten optischen Mediums liegt.

Gegenüber einer Laseranordnung hat hier die erfindungsgemäße Lichtquelle bzw. das Verfahren zur Lichterzeugung den besonderen Vorteil, dass das Pumplicht irgendwo und irgendwie, auch diffus, auf das optische Medium treffen kann und nicht wie bei der Laseranwendung einen möglichst großen Überlapp mit der Resonatormode aufweisen muss.

Auch kann die Pumpwellenlänge nahe der Emissionswellenlänge liegen und das Medium somit ohne Hitzeentwicklung genutzt werden. Beispielsweise kann die Pumpwellenlänge in einen Bereich des Absorptionsspektrums gelegt werden, der einen Überlapp aufweist mit dem Emissionsspektrum.

In einer anderen Anwendung kann die Photonenzahl unterhalb der kritischen Photonenanzahl eingestellt werden, welche Nc = (π/(3*(h̅c)²)) * (k_{b}T)² * D₀ * R entspricht, wobei T der Medientemperatur entspricht, D₀ dem Abstand der Spiegel der Resonatoren und R dem Radius eines als sphärisch angenommenen Spiegels in Kombination mit einem Planspiegel. Hierbei ist zu berücksichtigen, dass Resonatoren mit zwei gekrümmten Spiegeln effektiv auch auf Resonatoren mit einem gekrümmtem und einem planen Spiegel umgerechnet werden können.

Unterhalb dieser genannten kritischen Photonenanzahl im Resonator ist wie zuvor beschrieben die spektrale Lichtverteilung Bolzmann-verteilt mit einer langwelligen Grenzwellenlänge, die dem einzigen longitudinalen Mode entspricht, der durch die geometrische Resonatorkonfiguration definiert ist.

Oberhalb, wie auch unterhalb der kritischen Photonenzahl ergibt sich in Verbindung mit dem optischen Medium die Situation, dass im optischen Medium absorbierte Photonen durch die im optischen Medium mehrfach stattfindenden Emissions- und Reabsorptionsprozesse, insbesondere im thermischen Gleichgewicht, eine Energiekonversion zu längeren Wellenlängen, d.h. in Richtung zum energetischen Minimum hin stattfindet, nämlich dem Minimum, welches durch den Resonator als effektives Potential gegeben ist und dessen longitudinalen Grundmode entspricht.

Jegliches, im eingesetzten Medium absorbierte Photon wird damit im Endeffekt umgesetzt in langwelligere Photonen mit einer Bolzmannverteilung oder bei höherer Intensität in eine Bose-Einstein-Verteilung, jeweils mit dem Resonatorgrundmode als obere Grenzwellenlänge
Eine erfindungsgemäße Lichtquelle kann demnach beispielsweise eingesetzt werden, um Licht mit einer ersten Bandbreite, beispielsweise Sonnenlicht, zu konvertieren in Licht einer zweiten, gegenüber der ersten geringeren Bandbreite, die Bolzmann-verteilt oder Bose-Einstein-verteilt ist mit maximaler Intensität nahe der longitudinalen Grundmode (Boltzmann-verteilt) bzw. bei der longitudinalen Grundmode (Bose-Einstein verteilt).

Hierdurch erschließt sich, insbesondere bei geringen Intensitäten unterhalb der kritischen Photonenzahl, z.B. eine Anwendung in Verbindung mit Solarzellen, die üblicherweise maximale Energiekonversion im nahen Infrarotbereich, insbesondere um 800 Nanometer aufweisen, so dass sich mit einer erfindungsgemäßen Lichtquelle die Möglichkeit ergibt, Photonen im gesamten sichtbaren Spektrum und nahen Infrarotspektrum des Sonnenlichtes im optischen Medium einzufangen und in die Richtung zum nahen infraroten Spektralbereich zu verschieben, wenn nämlich der longitudinale Resonatormode auf die für Solarzellen typische Arbeitswellenlänge eingestellt wird.

Um ein entsprechend absorptionsbreites optisches Medium in diesem oder auch anderen Anwendungsfällen zur Verfügung zu stellen, kann es vorgesehen sein, nicht nur mit einem einzigen Zwei-Niveausystem als optisches Medium zu arbeiten, sondern gegebenenfalls gleichzeitig mit mehreren Zwei-Niveausystemen, beispielsweise in der Art einer Mischung mehrerer verschiedener Systeme, z.B. von Farbstoffen.

Hierbei ist es wesentlich, die eingesetzten Zwei-Niveau-Systeme derart auszuwählen, dass deren Absorptions- und Emissionsbanden einander zumindest teilweise überlappen, um im Zuge der mehrfach stattfindenden Emission und Reabsorption im optischen Medium zu ermöglichen, dass von einem Zwei-Niveau-System emittierte Photonen von einem anderen Zwei-Niveau-System wiederum absorbiert werden aufgrund des beschriebenen Überlapps.

So können effektiv alle innerhalb der so überlappend realisierten Absorptionsbandbreite eingefangenen Photonen in der Wellenlänge in Richtung zum einzigen longitudinalen Resonatormode verschoben werden und aus dem Resonator emittiert werden.

Es erschließt sich demnach bevorzugt eine Anwendung, bei der eine erfindungsgemäße Lichtquelle mit geeignet ausgewähltem optischem Medium in Verbindung mit Solarzellen zum Einsatz kommen kann.

Die erfindungsgemäße Lichtquelle ermöglicht hierbei neben der beschriebenen spektralen Sammelung auch eine räumliche Sammelung von Licht, da im Zuge der Annäherung an das thermodynamische Gleichgewicht beispielsweise an der Seite des Resonators auftreffendes Licht in Richtung der Mitte der Resonatoranordnung gezogen wird.

Dies ermöglicht die kostengünstige Verwendung von bzw. in Verbindung mit Solarzellen, die räumlich kleiner sind als die gesamte wirksame Fläche über die eine Lichtsammelung erfolgt. Anders als in Anordnungen zur Lichtsammelung nach dem Stand der Technik, beispielsweise Linsen- oder Spiegelanordnungen, ist hier keine räumliche Nachführung bei Änderung des Sonnenstands erforderlich. Des weiteren arbeitet die Anordnung gemäß der beschriebenen Erfindung auch mit diffusem Licht.

In einer anderen technischen Realisierung kann gegebenenfalls innerhalb der Lichtquelle bereits ein als Solarzelle wirkendes, also Licht in Elektrizität wandelndes Medium unmittelbar im oder angrenzend an den Resonator zum Einsatz kommen. Beispielweise kann ein solches Medium aussen an einen Spiegel des Resonators angekoppelt sein. Diese Medium kann ggfs selbst den Spiegel ausbilden, wenn es eine entsprechend gekrümmt Fläche aufweist, die reflektierend beschichtet ist. Auch kann ein solches Solar-Medium im Resonator direkt an das übrige optische Medium angekoppelt sein.

In einer anderen Anwendung erschließt sich auch die Möglichkeit, Farbstoffe als optisches Medium in Polymere einzubetten und diese als optische Medien in einer erfindungsgemäßen Spiegelkonfiguration, d.h. einen Resonator mit den zuvor beschriebenen Längenabständen zwischen den Spiegeln einzubetten und durch Anregung und Einstellung einer Photonenzahl oberhalb der kritischen Anzahl eine kohärente Lichtquelle zu realisieren.

So können beispielsweise Materialien, z.B. die bekannt gewordenen OLED-Materialien im Resonator eingesetzt werden, die auch elektrisch zur Lichtemission angeregt werden können, wobei durch entsprechendes Einstellen der Betriebsparameter, insbesondere der Photonenanzahl oberhalb der kritischen zuvor genannten Anzahl im thermischen Gleichgewicht eine kostengünstige, im Wirkungsgrad hocheffiziente elektrisch betriebene kohärente Lichtquelle realisiert werden kann.

Auch könnten atomare oder molekulare Gase als Medium verwendet werden, vorteilhaft erscheinen beispielsweise Edelgase bei hohem Druck. Stöße zwischen Edelgasatomen sind in hohem Maße elastisch, und die bei zunehmendem Druck ansteigende Zahl von Stößen zwischen den Atomen ermöglicht im Gas ein thermisches Gleichgewicht, das den an das Licht koppelnden atomaren Übergang mit einbezieht. Edelgase bieten nicht nur Übergänge im sichtbaren Spektralbereich, sondern auch im UV- oder Röntgenbereich. Durch Einstellung einer Photonenzahl oberhalb der kritischen Photonenzahl erschließt sich die Möglichkeit der Realisierung einer kohärenten Lichtquelle in diesem kurzwelligen Spektralbereich. Zur Lichtemission angeregt werden kann die erfindungsgemäße Lichtquelle beispielsweise mit einer Gasentladung innerhalb des Mediums, benachbart zum Medium oder auch um dieses herum oder durch die Bestrahlung mit einer externen Lichtquelle. Ein Beispiel für ein Einsatzgebiet solch kurzwelliger kohärenter Lichtquellen gemäß der dargestellten Erfindung sind Anwendungen in der UV- und EUV-Lithographie.

Optische Medien können allgemein bezogen auf alle möglichen Anwendungsfälle wie folgt bereit gestellt werden:
1. Farbstoffe die in flüssigen Lösungsmitteln gelöst sind. Solche Farbstofflösungen können z.B. zwischen den Resonatorspiegeln durch Adhäsionskräfte gehalten sein. Alternativ kann eine Küvette zwischen zwei Resonatorspiegeln angeordnet sein oder es können direkt Küvettenflächen verspiegelt sein, um Resonatorspiegel zu bilden.
2. Farbstoffe können in aushärtbare Matrixmaterialien, z.B. UV-Kleber eingemischt sein. Diese Mischungen können z.B. zwischen zwei Resonator-Spiegeln oder auf einem der Spiegel angeordnet und dort ausgehärtet sein.
3. Farbstoffe können auch als dünne Schicht, z.B. durch ein "Spin-Coating-Verfahren" auf einen oder beide Spiegel aufgebracht werden. Auch hierbei können die Farbstoffe in eine Matrix, z.B. eine Polymermatrix eingebunden sein.
4. Atomare oder molekulare Gase können in den Resonator gebracht werden. Dies kann insbesondere unter hohem Druck und/oder mit Puffergas unter hohem Druck geschehen, um die atomare/molekulare Resonanz zu verbreitern (Druckverbreiterung).

Die nachfolgend beschriebenen Figuren visualisieren das Grundprinzip der erfindungsgemäßen Lichtquelle. Es zeigen:
- Figur 1: eine symbolisierte Lichtquelle
- Figur 2: die spektrale Verteilung einer beispielsweise optisch angeregten erfindungsgemäßen Lichtquelle bei verschiedenen Intensitäten
- Figur 3: das Grundprinzip der Wellenlängen bzw. Frequenzkonversion oberhalb der kritischen Photonenzahl

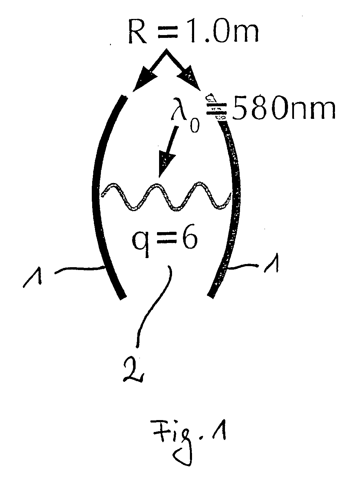

Die Figur 1 zeigt in einer symbolisierten Darstellung eine erfindungsgemäße Lichtquelle umfassend 2 gekrümmte Hohlspiegel 1, hier mit einem Krümmungsradius vom 1,0 Metern. Selbstverständlich können andere Krümmungsradien und Konfigurationen zum Einsatz kommen.

Wesentlich ist es jedoch wenigstens einen gekrümmten Spiegel einzusetzen, um neben dem longitudinalen Grundmode auch transversale Moden zuzulassen. Zwischen den Spiegeln 1 befindet sich, hier nicht separat dargestellt, das optische Medium 2, z.B. als ein Tropfen eines Farbstoffs, wie beispielsweise Rhodamin 6G. Es kann allgemein - auch bei anderen Ausführungen - vorgesehen sein, dass ein Farbstoff-Tropfen lediglich durch Adhäsionskräfte im Zwischenraum zwischen den Spiegeln gehalten ist. Der Spiegelabstand ist in diesem Beispiel auf N=6 Halbwellenlängen, insbesondere bezogen auf die Rh6G-Wellenlänge von 580 nm eingestellt, damit der freie Spektralbereich FSR des Resonators größer ist als die Absorptionsbandbreite des Farbstoffs. Ebenso können kleinere oder je nach Anwendung auch größere Zahlen N, bevorzugt mit 1 <= N <= 40 gewählt werden.

Alternativ kann es bei Festkörpermedien vorgesehen sein, einen Festkörper entsprechender Länge (n * Lambda/2, mit n bevorzugt kleiner 40, 10, 6 oder gleich 1) mit gekrümmten und reflektiv beschichteten Endflächen einzusetzen.

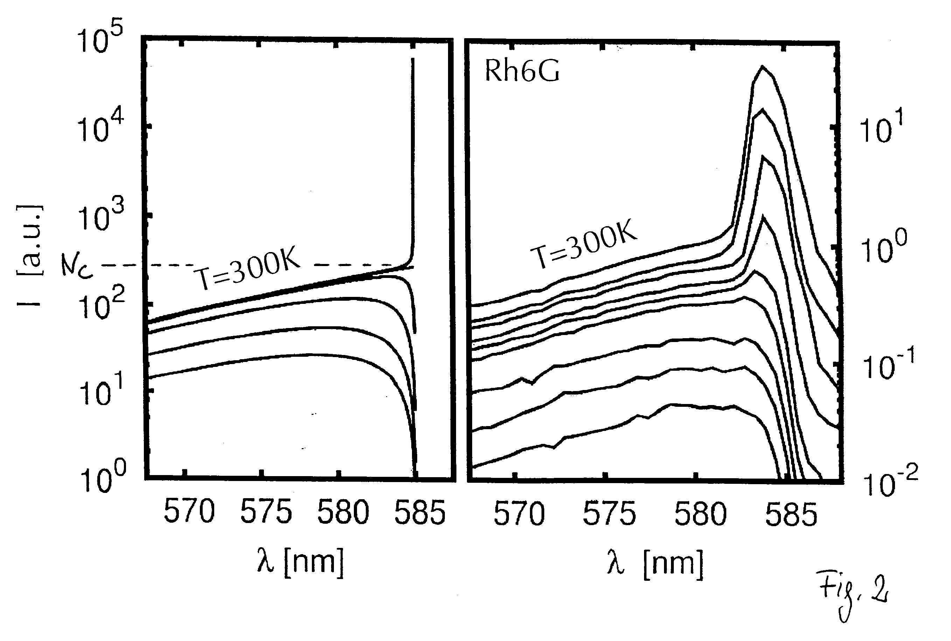

Die Figur 2 zeigt die spektrale Verteilung in theoretischer Berechnung (links) und in einem Experiment (rechts) gemessen, bezogen auf eine Resonatoranordnung mit einem optischen Medium aus dem Farbstoff Rodamin 6G in einer erfindungsgemäßen Anordnung, d.h. zwischen zwei Resonatorspiegeln mit einem Abstand von in diesem Experiment beispielhaften 6 * Lambda/2, wie in Figur 1 symbolisiert.

Die Figur 2 zeigt hier, dass sich durch optisches Pumpen dieses Farbstoffes innerhalb seiner Absorptionsbandbreite, hier beispielsweise um 532 Nanometer, ein intensitätsabhängiges Emissionsspektrum ergibt. So weist das Spektrum bei geringen Intensitäten kleiner einer Grenzintensität, insbesondere somit kleiner einer kritischen Photonenanzahl Nc eine typische Bolzmannverteilung auf mit einer oberen Grenzwellenlänge, die durch den Resonatorgrundmode definiert ist.

Die Figur 2 zeigt weiterhin, dass in einem Fall mit Intensitäten größer als eine Grenzintensität, insbesondere größer als die kritische Photonenanzahl Nc sich eine signifikante Intensitätsüberhöhung beim longitudinalen Grundmode einstellt, hier etwa bei 583 Nanometer, gegenüber den kurzwelligeren transversalen Moden. Diese Intensitätsüberhöhung ergibt sich aufgrund einer stattfindenden Bose-Einstein-Kondensation des Photonengases im thermischen Gleichgewicht oberhalb der kritischen Photonenanzahl, wodurch eine Emission von kohärentem Licht im Grundmode aus dem Resonator erzeugt wird. die Emission erfolgt hier bevorzugt durch wenigstens einen der Spiegel.

Es kann hier bei allen möglichen Ausführungen ein Resonator mit einer sehr hohen Finesse von beispielsweise größer 50.000, bevorzugt größer 100.000, weiter bevorzugt größer 200.000 eingesetzt werden.

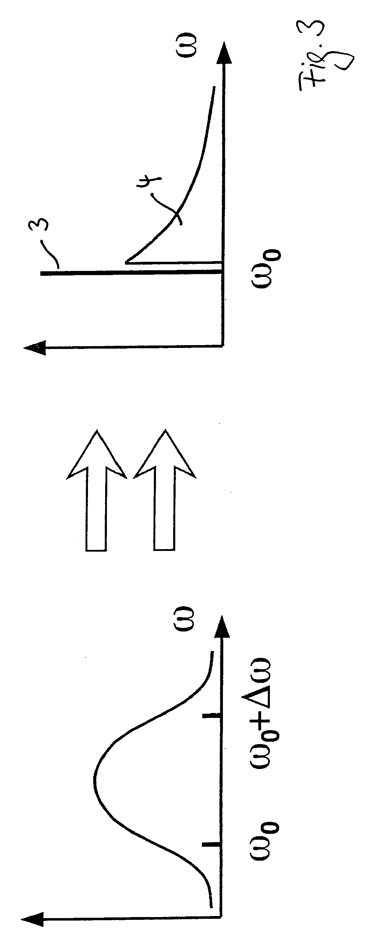

In symbolisierter Darstellung zeigt die Figur 3 in der Frequenzdomäne, dass Photonen im spektralen Bereich von der Frequenz ω₀ bis ω₀ + Δω, also innerhalb der Absorptions-, bevorzugt der Fluoreszenzbandbreite des eingesetzten optischen Mediums umgesetzt werden in eine Frequenzverteilung, wie sie rechtsseitig in der Figur 3 symbolisch dargestellt ist, sofern die Bedingungen des thermischen Gleichgewichts, das Überschreiten der kritischen Photonenanzahl und somit das Eintreten der Bose-Einstein-Kondensation auftritt.

Es ergibt sich sodann ein longitudinaler überhöhter Grundmode 3 mit kohärenter Lichtemission bei der Frequenz ω₀ sowie eine weitere Bose-Einstein-verteilte Charakteristik der weiteren transversalen Moden 4 des Resonators. Die durch die Photonen in das optische Medium durch Absorption eingetragene Energie wird demnach im Wesentlichen auf den Grundmode ω₀ des Resonators konzentriert, was einer Energie- bzw. Wellenlängenkonversion gleichkommt mit der Möglichkeit, oberhalb der kritischen Photonenanzahl kohärentes Licht zu erzeugen, wohingegen unterhalb der kritischen Photonenanzahl, so wie es die Figur 2 zeigt, im Wesentlichen ein Bolzmann-verteiltes Spektrum ergibt, das ebenso in Richtung zum Resonatorgrundmode eine energetische Konzentration aufweist.

Lichtquellen der erfindungsgemäßen Art weisen demnach den Vorteil auf, sowohl im nicht kohärenten als auch im kohärenten Betrieb die Möglichkeit zu erschließen, in das optische Medium eingestrahltes Licht einer hohen spektralen Bandbreitenverteilung auf eine demgegenüber vergleichsweise geringere Bandbreite, insbesondere um eine durch die Resonatorgeometrie eingestellte Wellenlänge zu konzentrieren, wobei der Konversionswirkungsgrad theoretisch 100% entspricht, sofern interne Verluste der Lichtquelle außer Acht gelassen werden. Lichtquellen der erfindungsgemäßen Art können aktiv elektrisch, chemisch oder optisch gepumpt werden mittels weiterer betriebener Pumpenergiequellen oder sogar "passiv" betrieben werden durch optisches Pumpen mittels ohnehin vorhandenem Umgebungslicht, insbesondere Sonnenlicht.

## Patentansprüche

1. Lichtquelle umfassend einen optischen Resonator (1) und ein darin angeordnetes zur Lichtemission anregbares optisches Medium (2), wobei das optische Medium (2) wenigstens ein 2-Niveau-System umfasst und der untere der beiden beteiligten Niveaus zumindest metastabil ist oder den Grundzustand des Mediums darstellt und die optische Länge des wenigstens einen gekrümmten Spiegel (1) umfassenden Resonators (1) so gewählt ist, dass dessen freie spektrale Bandbreite gleich groß oder größer ist als die Absorptions- und/oder Fluoreszenzbandbreite des optischen Mediums (2) und nur eine einzige longitudinale Mode und mehrere transversale Moden des Resonators (1) innerhalb der Fluoreszenzbandbreite angeordnet sind, **dadurch gekennzeichnet, dass** sie eingerichtet ist, im thermodynamischen Gleichgewicht des Strahlungsfeldes mit dem Medium (2) zu sein und eine Reabsorptionswahrscheinlichkeit der emittierten Photonen aufweist, die größer ist als 50%.

2. Lichtquelle nach Anspruch 1, **dadurch gekennzeichnet, dass** die Reabsorptionswahrscheinlichkeit größer ist als 75%.

3. Lichtquelle nach einem der vorherigen Ansprüche, **dadurch gekennzeichnet, dass** das die optische Resonatorlänge L = n * (Lambda/2) entspricht mit n kleiner gleich 40, bevorzugt n kleiner gleich 10, weiter bevorzugt n kleiner gleich 6, besonders bevorzugt n gleich 1.

4. Lichtquelle nach einem der vorherigen Ansprüche, **dadurch gekennzeichnet, dass** das optische Medium (2) eine Kombination mehrerer 2-Niveausysteme ist mit überlappenden Absorptions- und/oder Fluoreszenzbanden.

5. Lichtquelle nach einem der vorherigen Ansprüche, **dadurch gekennzeichnet, dass** sie unterhalb einer kritischen Photonenzahl im Resonator betrieben werden kann, bei welcher das Spektrum der aus der Lichtquelle emittierten Photonen Boltzmann-verteilt ist.

6. Lichtquelle nach einem der vorherigen Ansprüche, **dadurch gekennzeichnet, dass** sie oberhalb einer kritischen Photonenzahl im Resonator betrieben werden kann, bei welcher das Spektrum der aus der Lichtquelle emittierten Photonen Bose-Einstein-verteilt ist

7. Lichtquelle nach einem der vorherigen Ansprüche, **dadurch gekennzeichnet, dass** sie oberhalb einer kritischen Photonenzahl im Resonator betrieben werden kann, bei welcher das Spektrum der aus der Lichtquelle emittierten Photonen eine Bose-Einstein-Kondensation darstellt.

8. Lichtquelle nach einem der vorherigen Ansprüche, **dadurch gekennzeichnet, dass** das optische Medium (2) optisch angeregt werden kann durch Pumplicht einer Wellenlänge innerhalb der Absorptions- und/oder der Fluoreszenzbandbreite des optischen Mediums.

9. Lichtquelle nach einem der vorherigen Ansprüche, **dadurch gekennzeichnet, dass** sie optisch gepumpt werden kann durch eine benachbarte oder umgebende oder integrierte weitere Lichtquelle, die inkohärentes Licht innerhalb der Absorptionsbande / Fluoreszenzbande des wenigstens einen 2-Niveau-Systems des optischen Mediums (2) emittiert.

10. Verfahren zur Lichterzeugung mittels eines optischen Resonators (1) und einem darin angeordneten zur Lichtemission anregbaren optischen Medium (2), wobei als optisches Medium (2) wenigstens ein 2-Niveau-System gewählt wird, dessen unteres der beiden beteiligten Niveaus zumindest metastabil ist oder den Grundzustand des Mediums darstellt und die optische Länge des wenigstens einen gekrümmten Spiegel (1) umfassenden Resonators (1) so eingestellt wird, dass dessen freie spektrale Bandbreite größer ist als die Absorptions- und/oder Fluoreszenzbandbreite des optischen Mediums (2) und durch Anregung nur eine einzige longitudinale Mode (3) und mehrere transversale Moden (4) des Resonators (1) innerhalb der Fluoreszenzbandbreite des optischen Mediums (2) erzeugt werden, **dadurch gekennzeichnet, dass** sie im thermodynamischen Gleichgewicht des Strahlungsfeldes mit dem Medium (2) ist und eine Reabsorptionswahrscheinlichkeit der emittierten Photonen aufweist, die größer ist als 50%.

11. Verfahren nach Anspruch 10, **dadurch gekennzeichnet, dass** in das optische Medium (2) innerhalb dessen Absorptionsbandbreite nichtkohärentes Licht eingestrahlt wird und durch Einstellung der Photonenzahl im Resonator (1) über eine kritische Photonenzahl zumindest teilweise kohärentes spektral Bose-Einstein-verteiltes Licht emittiert wird.

12. Verfahren nach Anspruch 11, **dadurch gekennzeichnet, dass** in das optische Medium (2) Licht mit einer ersten Bandbreite, insbesondere Sonnenlicht eingestrahlt wird und mit einer zweiten, gegenüber der ersten geringeren Bandbreite Boltzmann-verteilt mit maximaler Intensität im oder nahe dem einzigen longitudinalen Mode als obere Grenzwellenlänge emittiert wird.

13. Verfahren nach einem der vorherigen Ansprüche 10 bis 12, **dadurch gekennzeichnet, dass** der Betrieb erfolgt, ohne Energie im Medium (2) zu deponieren oder so, dass das Medium (2) gekühlt wird, insbesondere durch geeignete Auswahl des Spektrums einer Pumplichtquelle.

14. Verfahren nach einem der vorherigen Ansprüche 10 bis 13, **dadurch gekennzeichnet, dass** die Reabsorptionswahrscheinlichkeit der emittierten Photonen größer ist als 75%.

## Claims

1. Light source comprising an optical resonator (1) and an optical medium (2) arranged therein and excitable for light emission, wherein the optical medium (2) comprises at least one two-level system and the lower of the two levels involved is at least metastable or represents the ground state of the medium and the optical length of the resonator (1) comprising at least one curved mirror (1) is chosen such that the free spectral bandwidth of said resonator is greater than or equal to the absorption and/or fluorescence bandwidth of the optical medium (2) and only a single longitudinal mode and a plurality of transverse modes of the resonator (1) are arranged within the fluorescence bandwidth, **characterized in that** said light source is configured to be in thermodynamic equilibrium of the radiation field with the medium (2) and has a reabsorption probability of the emitted photons that is greater than 50%.

2. Light source according to Claim 1, **characterized in that** the reabsorption probability is greater than 75%.

3. Light source according to either of the preceding claims, **characterized in that** the optical resonator length corresponds to L = n * (lambda/2) where n is less than or equal to 40, preferably n is less than or equal to 10, more preferably n is less than or equal to 6, particularly preferably n is equal to 1.

4. Light source according to any of the preceding claims, **characterized in that** the optical medium (2) is a combination of a plurality of two-level systems with overlapping absorption and/or fluorescence bands.

5. Light source according to any of the preceding claims, **characterized in that** it can be operated below a critical photon number in the resonator at which the spectrum of the photons emitted from the light source is Boltzmann-distributed.

6. Light source according to any of the preceding claims, **characterized in that** it can be operated above a critical photon number in the resonator at which the spectrum of the photons emitted from the light source is Bose-Einstein-distributed.

7. Light source according to any of the preceding claims, **characterized in that** it can be operated above a critical photon number in the resonator at which the spectrum of the photons emitted from the light source represents a Bose-Einstein condensation.

8. Light source according to any of the preceding claims, **characterized in that** the optical medium (2) can be optically excited by pump light having a wavelength within the absorption bandwidth and/or the fluorescence bandwidth of the optical medium.

9. Light source according to any of the preceding claims, **characterized in that** it can be optically pumped by an adjacent or surrounding or integrated further light source which emits incoherent light within the absorption band/fluorescence band of the at least one two-level system of the optical medium (2).

10. Method for generating light by means of an optical resonator (1) and an optical medium (2) arranged therein and excitable for light emission, wherein as the optical medium (2) at least one two-level system is chosen whose lower level of the two levels involved is at least metastable or represents the ground state of the medium and the optical length of the resonator (1) comprising at least one curved mirror (1) is set such that the free spectral bandwidth of said resonator is greater than the absorption and/or fluorescence bandwidth of the optical medium (2) and only a single longitudinal mode (3) and a plurality of transverse modes (4) of the resonator (1) are generated within the fluorescence bandwidth of the optical medium (2) by excitation, **characterized in that** said light source is in thermodynamic equilibrium of the radiation field with the medium (2) and has a reabsorption probability of the emitted photons that is greater than 50%.

11. Method according to Claim 10, **characterized in that** non-coherent light is radiated into the optical medium (2) within the absorption bandwidth thereof and at least partly coherent spectrally Bose-Einstein-distributed light is emitted by virtue of the setting of the photon number in the resonator (1) above a critical photon number.

12. Method according to Claim 11, **characterized in that** light having a first bandwidth, in particular sunlight, is radiated into the optical medium (2) and is emitted with a second bandwidth, smaller than the first bandwidth, in a Boltzmann-distributed manner with a maximum intensity in or near the single longitudinal mode as upper limiting wavelength.

13. Method according to any of the preceding Claims 10 to 12, **characterized in that** operation is performed without energy being deposited in the medium (2) or such that the medium (2) is cooled, in particular by suitable selection of the spectrum of a pump light source.

14. Method according to any of the preceding Claims 10 to 13, **characterized in that** the reabsorption probability of the emitted photons is greater than 75%.

## Revendications

1. Source de lumière comprenant un résonateur optique (1) et un milieu optique (2) disposé dans celui-ci et pouvant être excité pour l'émission de lumière, dans lequel le milieu optique (2) comprend au moins un système à 2 niveaux et dans lequel le plus bas des deux niveaux concernés est au moins métastable ou représente l'état fondamental du milieu et la longueur optique du résonateur (1) comprenant au moins un miroir courbe (1) est sélectionnée de manière à ce que sa largeur de bande spectrale libre soit identique ou supérieure à la largeur de bande d'absorption et/ou de fluorescence du milieu optique (2) et dans lequel seul un mode longitudinal unique et plusieurs modes transversaux du résonateur (1) sont contenus à l'intérieur de la largeur de bande de fluorescence, **caractérisée en ce qu'**elle est conçue de manière à présenter un équilibre thermodynamique du champ de rayonnement avec le milieu (2) et **en ce qu'**elle présente une probabilité de réabsorption des photons émis supérieure à 50 %.

2. Source de lumière selon la revendication 1, **caractérisée en ce que** la probabilité de réabsorption est supérieure à 75 %.

3. Source de lumière selon l'une quelconque des revendications précédentes, **caractérisée en ce que** la longueur du résonateur optique L = n * (Lambda/2) correspond à n inférieur ou égal 40, de préférence, à n inférieur ou égal à 10, de façon plus préférable, à n inférieur à 6, et de façon particulièrement préférable, à n égal à 1.

4. Source de lumière selon l'une quelconque des revendications précédentes, **caractérisée en ce que** le milieu optique (2) est une combinaison de plusieurs systèmes à 2 niveaux ayant des bandes d'absorption et/ou de fluorescence se chevauchant.

5. Source de lumière selon l'une quelconque des revendications précédentes, **caractérisée en ce qu'**elle peut être mise en fonctionnement en dessous d'un nombre critique de photons dans le résonateur, pour lequel le spectre des photons émis par la source de lumière présente une distribution de Boltzmann.

6. Source de lumière selon l'une quelconque des revendications précédentes, **caractérisée en ce qu'**elle peut être mise en fonctionnement au-dessus d'un nombre critique de photons dans le résonateur, pour lequel le spectre des photons émis par la source de lumière présente'une distribution de Bose-Einstein.

7. Source de lumière selon l'une quelconque des revendications précédentes, **caractérisée en ce qu'**elle peut être mise en fonctionnement au-dessus d'un nombre critique de photons dans le résonateur, pour lequel le spectre des photons émis par la source de lumière représente une condensation de Bose-Einstein.

8. Source de lumière selon l'une quelconque des revendications précédentes, **caractérisée en ce que** le milieu optique (2) peut être excité optiquement par une lumière de pompage ayant une longueur d'onde se situant dans la largeur de bande d'absorption et/ou de fluorescence du milieu optique.

9. Source de lumière selon l'une quelconque des revendications précédentes, **caractérisée en ce qu'**elle peut être pompée optiquement par une autre source de lumière l'entourant ou intégrée qui émet une lumière incohérente se situant à l'intérieur des bandes d'absorption de fluorescence de l'au moins un système à 2 niveaux du milieu optique (2).

10. Procédé pour générer de la lumière au moyen d'un résonateur optique (1) et d'un milieu optique (2) disposé dans celui-ci et pouvant être excité pour l'émission de lumière, dans lequel au moins un système à 2 niveaux est sélectionné en tant que milieu optique (2), dont le plus bas des deux niveaux concernés est au moins métastable ou représente l'état fondamental du milieu et la longueur optique de l'au moins un résonateur (1) comprenant au moins un miroir courbe (1) est sélectionnée de manière à ce que sa largeur de bande spectrale libre soit supérieure à la largeur de bande d'absorption et/ou de fluorescence du milieu optique (2) et dans lequel un mode longitudinal unique (3) et plusieurs modes transversaux (4) du résonateur (1) sont générés à l'intérieur de la largeur de bande de fluorescence du milieu optique (2), **caractérisé en ce qu'**il présente un équilibre thermodynamique du champ de rayonnement avec le milieu (2) et **en ce qu'**il présente une probabilité de réabsorption des photons émis supérieure à 50 %.

11. Procédé selon la revendication 10, **caractérisé en ce que** de la lumière non cohérente est injectée dans le milieu optique (2) à l'intérieur de sa largeur de bande d'absorption et **en ce que** de la lumière présentant une distribution spectrale de Bose-Einstein au moins partiellement cohérente est émise par utilisation d'un nombre de photons dans le résonateur (1) qui est supérieur à un nombre critique de photons.

12. Procédé selon la revendication 11, **caractérisé en ce qu'**une lumière ayant une première largeur de bande, notamment de la lumière solaire, est injectée dans le milieu optique (2) et **en ce qu'**elle est émise avec une deuxième largeur de bande inférieure à la première largeur de bande de manière à présenter une distribution de Boltzmann avec une intensité maximale dans le mode longitudinal unique ou à proximité de celui-ci en tant que longueur d'onde limite supérieure.

13. Procédé selon l'une quelconque des revendications 10 à 12, **caractérisé en ce que** le fonctionnement s'effectue sans dépôt d'énergie dans le milieu (2) ou de manière à ce que le milieu (2) soit refroidi, notamment par une sélection appropriée du spectre d'une source de lumière de pompage.

14. Procédé selon l'une quelconque des revendications 10 à 13 précédentes, **caractérisé en ce que** la probabilité de réabsorption des photons émis est supérieure à 75 %.
